# FASCICULE DE BREVET EUROPEEN

(11) **EP 0 760 149 B1**
(45) Date de publication et mention de la délivrance du brevet: **14.11.2001**
(21) Numéro de dépôt: 95920943.8
(22) Date de dépôt: 16.05.1995
(51) Int. Cl.: G09G 3/36, G11C 19/28

(54) **REGISTRE A DECALAGE UTILISANT DES TRANSISTORS M.I.S. DE MEME POLARITE**
SCHIEBEREGISTER MIT GLEICH POLARISIERTEN MIS-TRANSISTOREN
SHIFT REGISTER USING MIS TRANSISTORS HAVING THE SAME POLARITY

(30) Priorité: 17.05.1994 FR 9405987
(43) Date de publication de la demande: 05.03.1997
(73) Titulaire: THOMSON-LCD, 75008 Paris (FR)
(72) Inventeur: MAURICE, François, F-92050 Paris-La Défense (FR)
(74) Mandataire: Ruellan-Lemonnier, Brigitte
(86) Numéro de dépôt international: FR9500634
(87) Numéro de publication internationale: WO9531804

(56) Documents cités:
- WO-A-92/09985
- GB-A- 2 022 953
- US-A- 4 035 662
- US-A- 4 163 291
- PATENT ABSTRACTS OF JAPAN vol. 9 no. 210 (P-383) [1933] ,28 Août 1985 & JP,A,60 070599 (SEIKO)

## Description

La présente invention a pour objet un registre à décalage pouvant ne comporter que trois transistors M.I.S. et des perfectionnements de ce circuit, et permettant en particulier la sélection de lignes de pixels d'un écran plat.

Un écran plat à cristaux liquides est constitué d'un certain nombre de cellules électro-optiques arrangées en lignes et colonnes, commandées chacune par un dispositif de commutation et comportant deux électrodes encadrant un cristal liquide dont les propriétés optiques sont modifiées en fonction de la valeur du champ qui le traverse. L'ensemble dispositif de commutation / électrode / cristal liquide / contre-électrode constitue un "pixel" (pour "picture element"). L'adressage par l'électronique de commande périphérique de ces pixels s'effectue par l'intermédiaire de lignes (lignes de sélections) qui commandent l'état passant et non-passant des dispositifs de commutation, et de colonnes (lignes de données) transmettant, lorsque le dispositif de commutation est passant, une tension à appliquer aux bornes des électrodes correspondant au signal de données à afficher (échelle de gris).

Les électrodes, les dispositifs de commutation, les lignes et les colonnes sont déposés et gravés sur une même plaque substrat, ils constituent la matrice active de l'écran. Avantageusement, les circuits de commande périphériques, c'est à dire, le balayeur de lignes de sélections, qui sélectionne les lignes horizontales à afficher, et les circuits qui commandent les lignes de données, sont intégrés sur la plaque substrat comportant la matrice active et fabriqués en même temps que celle-ci.

Dans un écran plat de télévision ou d'ordinateur, le fait que le nombre de pixels soit très important, que le pas du réseau de ces pixels soit très petit, limitant ainsi l'espace disponible pour disposer le circuit de commande, et qu'un grand nombre de lignes de sélection et de lignes de données soient nécessaires, impose d'avoir des circuits de commande les plus petits et les plus simples possibles afin d'arriver à un haut degré de rendement de fabrication. Il peut par ailleurs être avantageux d'utiliser des dispositifs semiconducteurs comme dispositifs de commutation des pixels, du même type de conductivité dans tout l'afficheur.

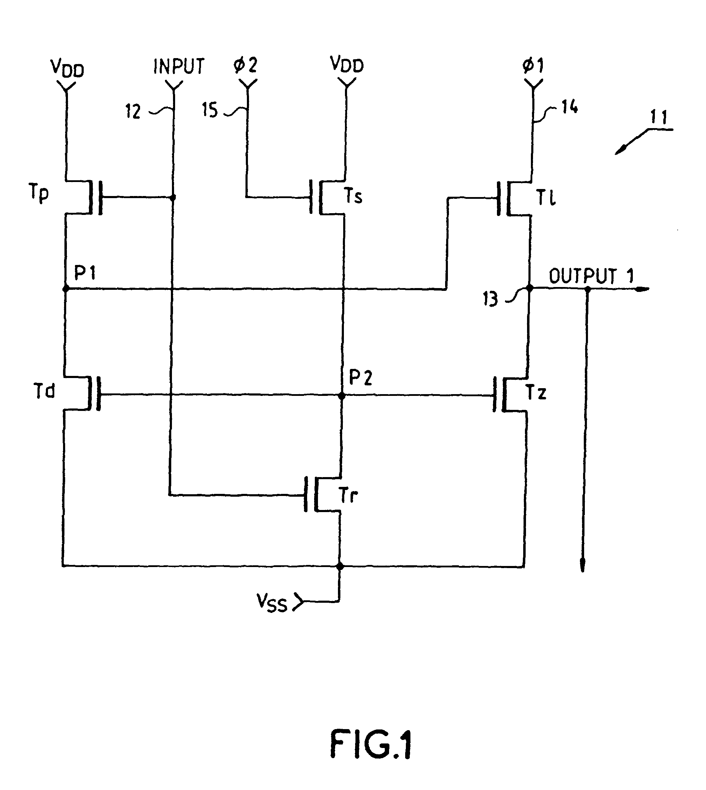

La commande de ces dispositifs semiconducteurs peut être faite par des lignes adressées par un ou plusieurs registres à décalage. Une structure de registre telle que celle représentée sur la figure 1, permet en partie de répondre aux exigences évoquées dans le paragraphe précédent. Un étage 11 d'un registre comporte six transistors Tp, Td, Ts, Tr, Tl et Tz, et est alimenté par deux signaux d'horloge Φ1 et Φ3 en 14 et 15, ainsi que par deux sources positives Vdd et une source négative Vss (relativement). Le fonctionnement d'un registre à décalage constitué de tels étages est décrit en détails dans la demande de brevet Internationale WO 92/15992, voir aussi WO-A- 92/09985, les deux déposés par Thomson LCD. Ce fonctionnement repose sur le fait que la grille du transistor Tl qui commande la sortie 13 de l'étage du registre est laissée flottante, et qu'ainsi son potentiel suit par effet capacitif ceux de l'horloge et de la sortie. C'est l'effet "Bo-of-strap" en langue anglaise. Cela permet, au moment voulu, la charge complète de la sortie 13 au potentiel le plus élevé de l'horloge Φ1. Le transistor Tp permet de précharger la grille du transistor Tl, et le transistor Td de décharger celle-ci.

Lorsque l'étage en question n'est pas sélectionné, sa sortie 13 doit rester au potentiel Vss. Cependant le drain du transistor Tl est excité en permanence par l'horloge Φ1, et une conséquence de l'effet bootstrap décrit plus haut est que, à chaque coup d'horloge Φ1, la grille du transistor Tl récupère environ la moitié de l'amplitude des signaux de Φ1 (typiquement une dizaine de volts), et celui-ci devient alors légèrement passant. Il est donc nécessaire de rendre passant le transistor Tz afin d'écouler les charges du noeud de la sortie 13 et forcer celui-ci au potentiel Vss. De même, le transistor Td doit être maintenu passant pendant le même temps pour ramener en permanence la tension de grille du transistor Tl à la valeur Vss. Les transistors Td et Tz doivent donc avoir une tension de commande toujours positive, sauf lorsque l'étage est sélectionné. Cette tension de commande au noeud P2 est commandée par une bascule R/S (pour "Reset/Set") composée de deux transistors Tr (Reset) et Ts (Set), les dimensions du transistor Tr étant plus grandes que celle du transistor Ts, le reset est prioritaire. L'horloge Φβ actionne en 15 régulièrement le transistor-set Ts, portant le noeud P2 à Vdd, jusqu'à ce que l'entrée force en 12 le transistor-reset Tr prioritaire pour bloquer le transistor Tz et permettre au transistor Tl passant de polariser le noeud 13 de sortie.

En résumé, si l'effet de bootstrap permet une bonne charge des sorties, il s'accompagne d'effets parasites qui nécessitent l'utilisation de trois transistors supplémentaires Tz, Tr et Ts. Un autre inconvénient de la solution décrite sur la figure 1 est que les transistors Td et Tz subissent en permanence un stress de grille (c'est à dire une tension positive sur la grille) qui peut avoir pour conséquence une dérive de leur tension de seuil, et à terme un dysfonctionnement de l'ensemble du dispositif.

La présente invention permet d'éviter ces inconvénients, et propose des circuits simples à trois, quatre ou sept transistors, ayant des durées de vie rallongées, selon les modes de réalisation de l'invention couverts par les revendications 1-5.

La présente invention s'étend aussi à tous les types d'écrans plats à matrice active utilisant des circuits de commande périphériques ou intégrés avec de tels registres à décalage.

D'autre part, l'invention s'étend aussi aux écrans munis d'un perfectionnement consistant à rajouter une colonne conductrice supplémentaire croisant les lignes de sélection et couplée capacitivement à chacune de celles-ci de manière à ce que les capacités de couplage correspondantes aient chacune une valeur voisine de la somme des capacités de couplage entre une ligne et les colonnes qu'elle croise. Cette colonne supplémentaire peut aussi être associée à une ligne conductrice supplémentaire couplée capacitivement avec elle et associée avec elle au travers d'un circuit comparateur, cette ligne supplémentaire étant couplée capacitivement à chacune des colonnes.

L'effet bootstrap décrit plus haut est obtenu sans contrepartie. Lorsque l'étage est au repos, il n'y a plus de stress de grille positif, et trois transistors, une horloge et une alimentation peuvent être éliminés par rapport à l'état antérieur de la technique, et, d'autre part, deux modes de réalisation de l'invention à sept et quatre transistors permettent de travailler avec des signaux de commande ayant une amplitude de 5 à 10 volts inférieure à celle des signaux de sortie.

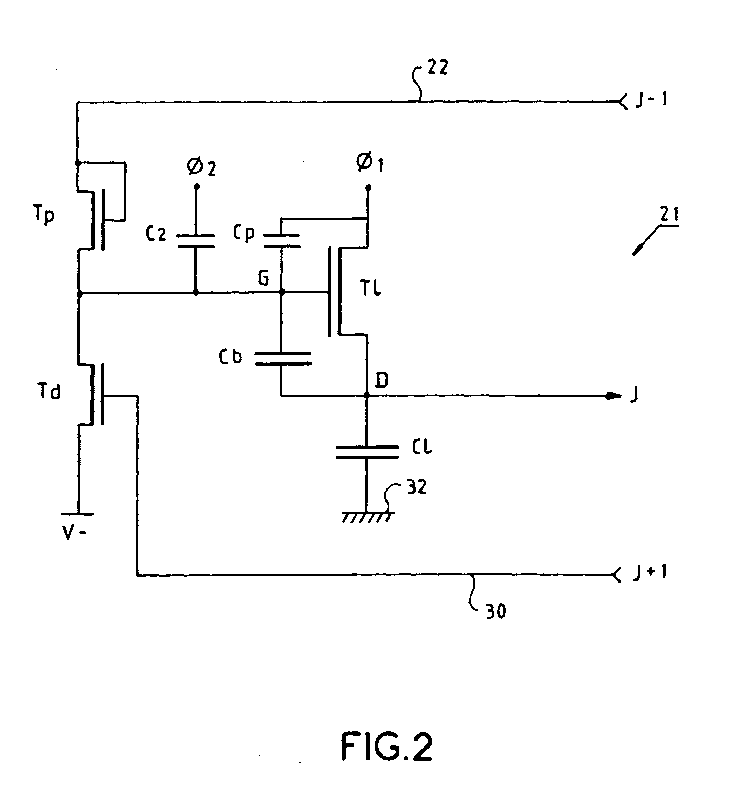

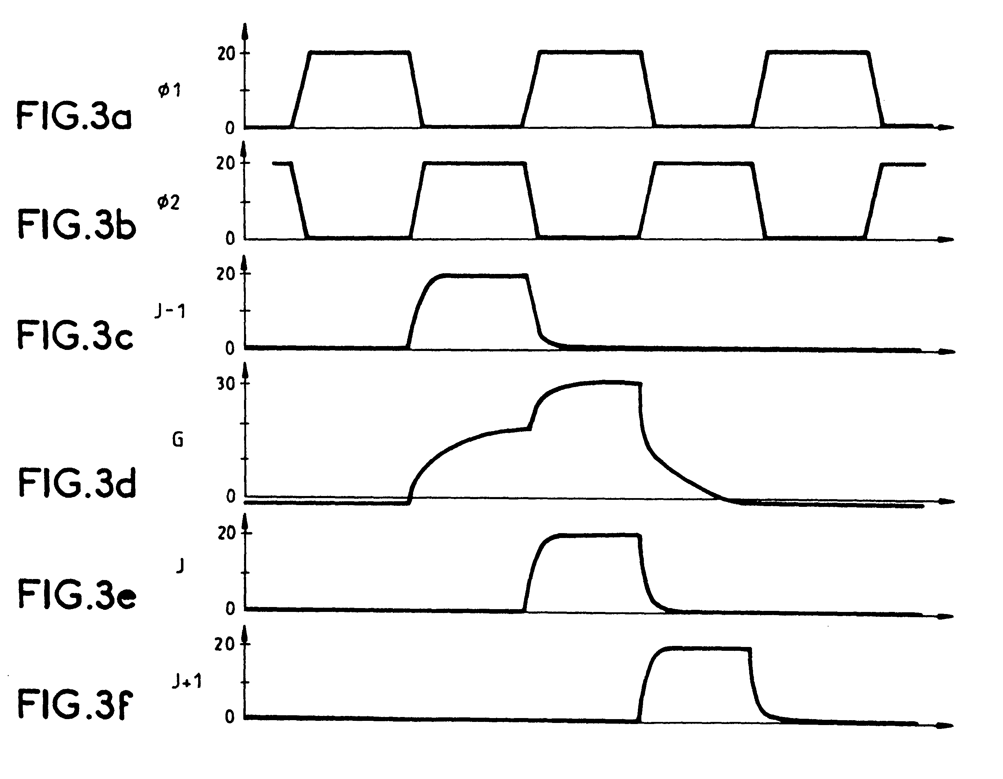

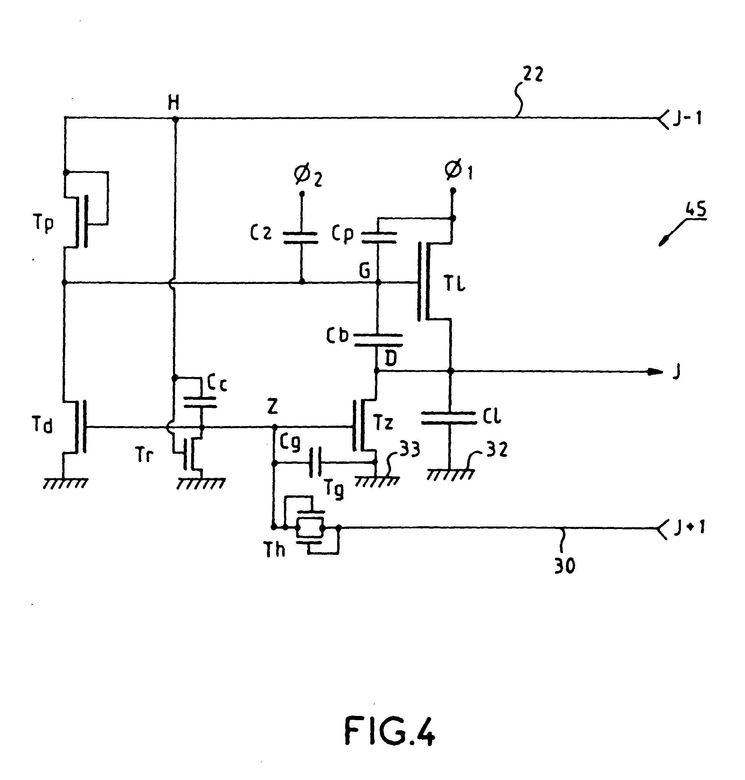

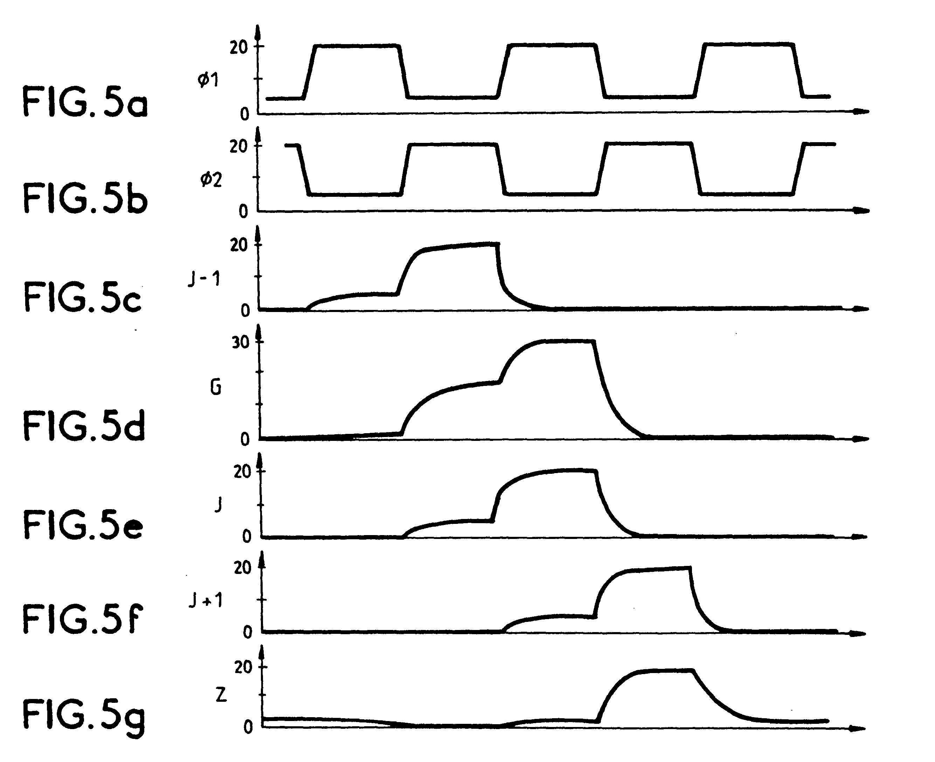

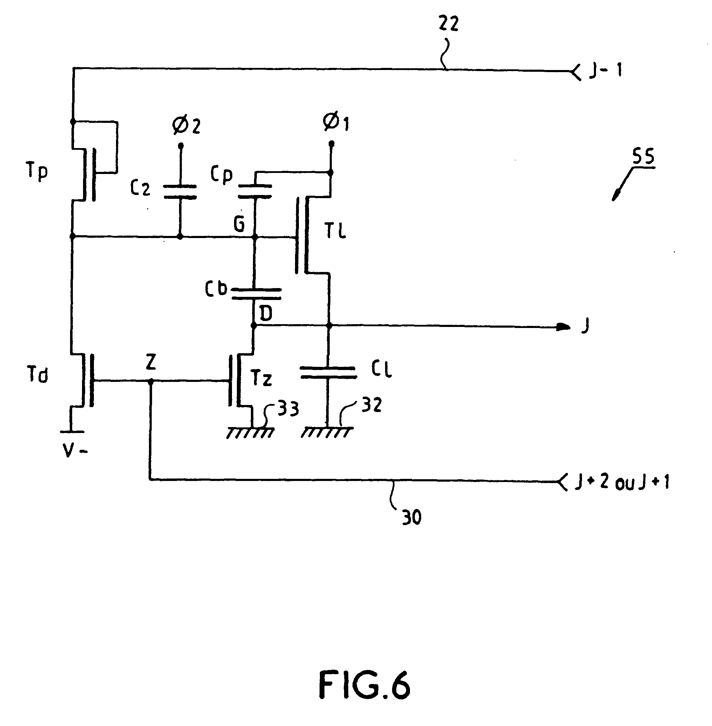

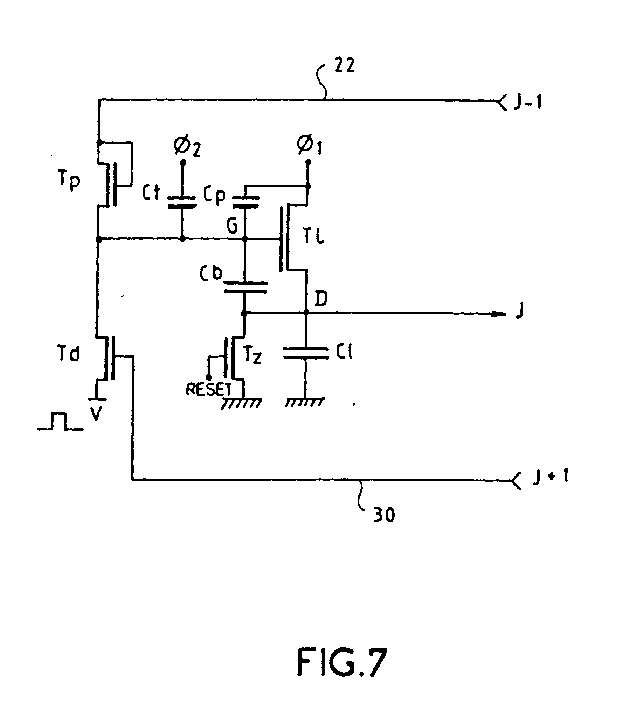

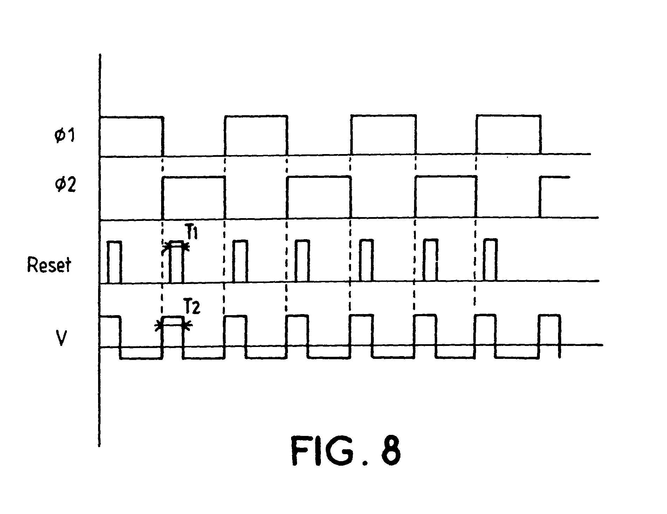

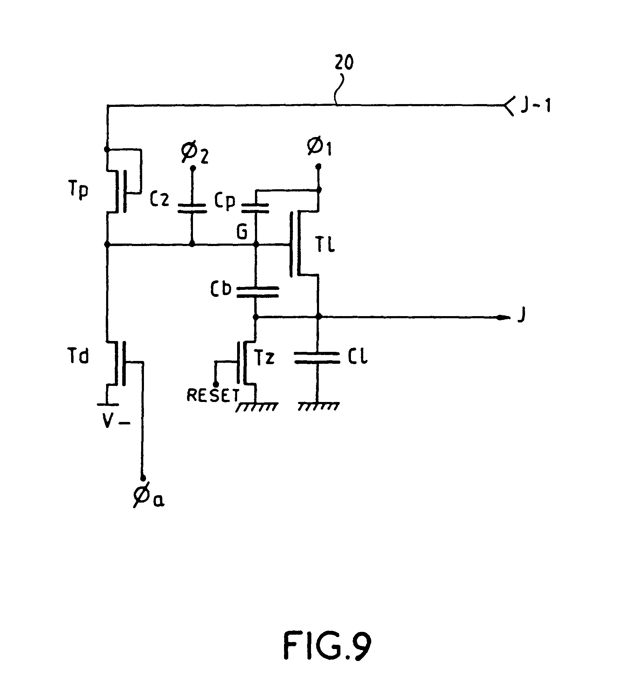

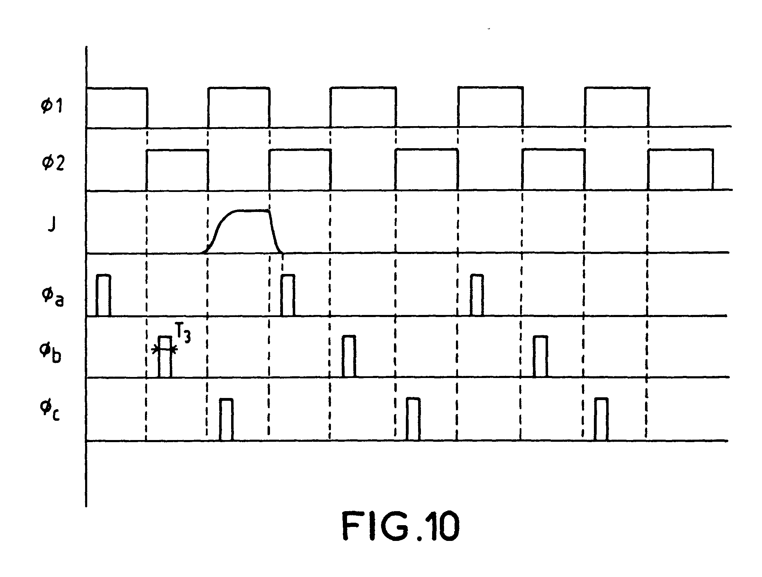

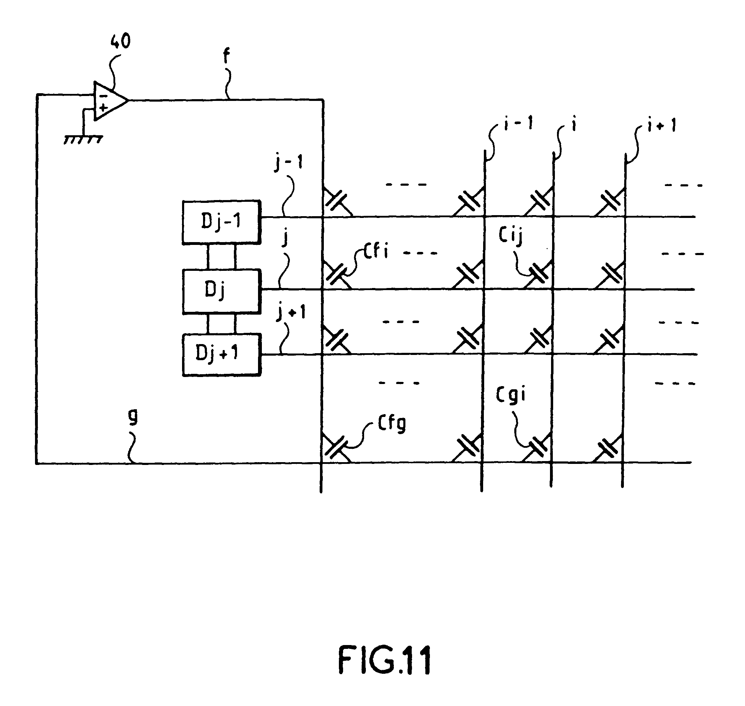

La présente invention sera mieux comprise et des avantages supplémentaires apparaitront à la lecture de la description qui va suivre illustrée par les figures suivantes:
. la figure 1 déjà décrite représente un étage 11 d'un registre à décalage selon l'état de l'art antérieur,
. la figure 2 représente un premier mode de réalisation d'un étage de registre à décalage selon l'invention utilisant trois transistors,
. les figures 3a à 3f représentent le chronogramme des éléments du dispositif de la figure 2,
. la figure 4 représente un second mode de réalisation de l'invention utilisant sept transistors,
. les figures 5a à 5g représentent un exemple de chronogramme des éléments du dispositif de la figure 4,
. la figure 6 représente un troisième mode de réalisation de l'invention utilisant quatre transistors,
. la figure 7 représente un quatrième mode de réalisation de l'invention utilisant aussi quatre transistors,
. la figure 8 représente le chronogramme du dispositif de la figure 7,
. la figure 9 représente un cinquième mode de réalisation de l'invention utilisant quatre transistors,
. la figure 10 représente le chronogramme du dispositif de la figure 9,
. et la figure 11 représente un perfectionnement de la présente invention.

Sur les différentes figures, les éléments ayant une fonction identique ou équivalente d'une figure à l'autre, ont gardé les mêmes références. Les différents modes de réalisation de l'invention représentés sur ces figures sont des étages de registres à décalage de drivers intégrés commandant des écrans à cristaux liquide réalisés avec des transistors en couches minces, mais il est bien évident que l'invention s'applique à tous les types de circuits électroniques grandes surfaces réalisés avec des dispositifs semiconducteurs quelconques.

Selon la présente invention, sur la figure 2, est représenté un étage 21 à trois transistors Tl, Tp et Td, d'un registre à décalage commandant une ligne de sélection J, et connecté en 22 à la ligne précédente J-1 ainsi qu'à la ligne suivante J+1 en 30. Ce circuit est d'autre part alimenté par une source négative (relativement) V- et deux horloges Φ1 et Φ2. La structure de ce circuit est décrite ci-dessous.

Cet étage est connecté en 22 à la ligne précédente J-1 par le drain du transistor Tp, transistor de précharge de la grille du transistor Tl qui commande le noeud D de la sortie sur la ligne J. La grille du transistor Tp étant connectée à son drain, ce transistor Tl est rendu passant par le potentiel de la ligne J-1 de sortie de l'étage précédent en 22. Le transistor Tp commande le noeud G relié à la source négative V- par le transistor Td, lui même commandé par le potentiel de la ligne J+1 de sortie de l'étage suivant en 30.

Le noeud D est connecté à la source du transistor Tl, au noeud G par l'intermédiaire d'une capacité Cb, et à la ligne J à sélectionner, dont la charge est symbolisée électriquement par une capacité Cl.

Un signal d'horloge Φ1 est appliqué sur le drain du transistor de sortie TI. Il existe entre le drain et la grille (noeud G) de ce transistor une capacité parasite Cp responsable de l'effet bootstrap décrit plus haut à partir de la figure 1 de l'art antérieur. Selon une caractéristique importante de l'invention, une horloge Φ2 exactement complémentaire de l'horloge Φ1 est connectée au noeud G par l'intermédiaire d'une capacité C2, d'une valeur équivalente à celle de la capacité parasite Cp.

Ainsi, ces effets parasites - conséquences de l'effet bootstrap - sont contrebalancés grâce à la liaison de l'horloge Φ2 complémentaire de l'horloge Φ1, avec la grille du transistor Tl par l'intermédiaire de la capacité C2 de valeur Ct équivalente à celle de Cp. Les deux horloges étant exactement complémentaires, elles n'induisent aucune tension parasite au noeud G, donc à la grille du transistor TI. Un circuit équivalent comporte une capacité Cl = 2xCt entre le noeud G et la masse 32.

Une telle structure réduisant l'effet de bootstrap, il est nécessaire d'ajouter une capacité-bootstrap Cb entre le noeud-source D et le noeud-grille G afin que la tension de la grille suive une fraction Cb/(Cb+2xCp) des variations de la tension de source. Ainsi, il suffit, pour qu'un ratio de bootstrap de 60% soit atteint, que Cb ait trois fois la valeur de Ct.

Ainsi, un tel circuit conserve l'effet bootstrap sans ses effets secondaires décrits plus haut. La durée de vie du circuit, et donc de l'ensemble du dispositif est rallongée, et le nombre de transistors nécessaires a été divisé par deux par rapport à l'art antérieur. Un avantage supplémentaire de ce mode de réalisation de la présente invention est que les alimentations positives Vdd de l'art antérieur ont été éliminées. En effet, la grille et le drain du transistor de précharge Tp étant connectés, lorsque l'étage 21 n'est pas sélectionné, les deux transistors en série Tp et Td réalisent la fonction du transistor Tz de la figure 1, tirant du courant de la ligne J-1 vers la tension négative V-. Les deux transistors ont alors des tensions grille-source inférieures à leur tension de seuil, et leur courant de canal est une fonction exponentielle de ces tensions. Il résulte de cette disposition que la tension de grille du transistor Tl est inférieure d'environ 1 volt à sa tension de source, et celui-ci sera donc mieux bloqué que dans l'art antérieur, où les deux tensions sont égales. Ainsi, lorsqu'un étage du registre selon l'invention n'est pas sélectionné, tous ses transistors ont une tension de grille inférieure à leurs tensions de seuil, d'où une fatigue minimisée.

Le fonctionnement de ce circuit sera mieux compris à la lumière des chronogrammes 3a à 3f, chacun d'eux montrant en abscisse une échelle de temps et en ordonnée un potentiel. Lorsque l'étage J-1 précédent envoie une impulsion (figure 3c) en 22, le transistor de précharge Tp est passant et charge la capacité de bootstrap Cb. Le potentiel du noeud-grille G (figure 3d) monte jusqu'à celui de la ligne J-1 correspondant à l'étage précédent, auquel il faut retrancher sensiblement la valeur de la tension de seuil du transistor Tp. Le transistor Tl est alors passant. Lorsque l'horloge Φ1 monte à son tour (figure 3a), de même que dans l'art antérieur de la figure 1, la sortie J suit, entrainant la grille du transistor Tl grâce à la capacité de bootstrap Cb (figure 3d). Le transistor Tl est alors largement passant et le noeud D et la ligne J suivent parfaitement le potentiel de l'horloge Φ1 (figure 3e) jusqu'à sa descente. A ce moment la ligne suivante J+1 monte (figure 3f) et rend passant le transistor Td qui décharge la capacité de bootstrap Cb de sorte que le transistor Tl n'est plus passant pour les coups d'horloge suivants (figure 3d).

Le transistor Td ne doit pas être surdimensionné, afin que le transistor Tl reste passant assez longtemps pour que la sortie J revienne complètement à zéro. Comme la source du transistor Tl est polarisée légèrement négativement, le noeud G atteint une tension négative au repos, de sorte que le transistor Tl est bloqué plus surement que dans l'art antérieur de la figure 1.

Sur la figure 4 est représenté un second mode de réalisation d'un étage 45 d'un registre à décalage selon l'invention. On retrouve sur cette figure les trois transistors Tl, Tp et Td, les deux entrées J-1 en 22 et J+1 en 30 correspondant respectivement aux étages précédent et suivant, les deux entrées d'horloges Φ1 et Φ2 en opposition, la sortie J de l'étage 45 sur la ligne de sélection J associée, ainsi que les capacités Cp, C2, Cb et Cl, du mode de réalisation de l'invention décrit à partir des figures 2 et 3a à 3g.

Selon une caractéristique importante de l'invention, un transistor de remise à zéro Tz de la source du transistor de sortie Tl relie la capacité de bootstrap Cb à la masse en 33. La grille de ce transistor 47 est commandée par le noeud Z, relié d'un côté à la grille du transistor de décharge Td, et d'autre part à la ligne J + 1 suivante par l'intermédiaire de deux transistors de clamp (grille reliée à la source) Th et Tg montés en parallèle tête-bêche, les drains des deux transistors étant reliés aux sources et les grilles commandées par les sources. C'est à dire que l'un, le transistor Tg est commandé par le noeud Z, et l'autre, le transistor Th, par la ligne de l'étage suivant J+1. Une capacité Cg est reliée d'un côté au noeud Z et de l'autre à la masse en 33.

Par ailleurs, le transistor Td connecte le noeud G à la masse, et sa grille est commandée par le noeud Z. Celui-ci est relié à la masse au travers d'un transistor Tr dont la grille est commandée par le noeud H, c'est à dire par la sortie J-1 de l'étage précédent. Le noeud Z est d'autre part relié au noeud H par une capacité Cc.

Le fonctionnement de ce circuit est essentiellement celui, pour les parties communes, du circuit des figures 2 et 3a à 3f du mode de réalisation de l'invention précédent. Le perfectionnement par rapport à ce dernier est qu'au repos, les grilles des transistors Tz et Td, c'est à dire le noeud Z, sont maintenues au niveau de leur tension de seuil. Ces transistors sont alors suffisamment passants pour maintenir les noeuds G et D au potentiel bas. Dans ce cas, le transistor Tp ne sert plus dans ces conditions à ramener le potentiel des sorties au point bas. Grâce aux deux transistors Th et Tg par lesquels il est relié à la ligne 30 (ligne de l'étage suivant), le potentiel du noeud Z est maintenu à la tension de seuil des transistors Td et Tz. Le noeud Z va donc suivre les variations de tension de J+1 avec un retard de tension équivalent à la tension de seuil des transistors. Ainsi, lorsque J+1 monte, le noeud Z atteint la tension positive moins la tension de seuil, et les potentiels des noeuds G et D sont ramenés à zéro, les transistors Td et Tz étant alors parfaitement passants.

Lorsque le potentiel de la ligne J+1 revient à zéro, le potentiel du noeud Z conserve la valeur de la tension de seuil des transistors Tp et Tz qui conservent une certaine conductivité.

Le rôle de la capacité Cc est d'affaiblir l'effet des couplages capacitifs au travers des transistors Th et Tg vers la ligne J-1, ainsi que vers les source et grille du transistor TI.

Au repos, ce dernier a une tension de grille qui n'est plus négative, mais nulle. Son état passant est donc meilleur que dans la solution précédente à trois transistors. Le transistor Tz l'emportera cependant sur le transistor Tl car il est polarisé à son seuil de conduction. Ainsi se trouve garanti le retour à zéro des sorties au repos. Un autre avantage de cette solution à sept transistors est que l'impédance de sortie de l'étage 45 est plus basse que celle de la solution à trois transistors.

Le noeud Z étant relativement à haute impédance, le transistor Tr permet de ramener la tension de grille des transistors Td et Tz à zéro au moment de la précharge, c'est à dire lorsque l'étage est présélectionné. Le transistor Td bloqué permettra à la charge de la capacité Cb d'être plus complète, et le transistor Tr bloqué permettra à la sortie de monter à son niveau maximum. Enfin, afin d'éviter une remontée de la tension du noeud Z lorsque le niveau de la sortie monte, la capacité Cc doit être de valeur équivalente à celle de la capacité grille-drain du transistor Tz.

Le fonctionnement de ce circuit sera mieux compris à la lumière des chronogrammes 5a à 5g, chacun d'eux montrant en abscisse une échelle de temps et en ordonnée un potentiel lorsque les horloges ont une excursion moins importante que celle des sorties. De même que dans le mode de réalisation précédent, les horloges Φ1 et Φ2 sont en opposition (figures 5a et 5b). Les sorties J-1 (figure 5c), J (figure 5e) et J+1 (figure 5f) comportent trois paliers: le niveau de tension basse du dispositif au repos, le niveau bas des horloges lorsque J-1 est actif, et le niveau haut des horloges à la sélection.

Lorsque l'étage 45 est sélectionné, c'est à dire pour que la ligne J, sortie de l'étage 45, soit convenablement chargée (figure 5e), il faut que le noeud Z reste au niveau de la tension de seuil des transistors Td et Tz. Or, à cet instant, J+1 est au niveau bas des horloges (figure 5f). Compte tenu de l'existence des transistors Th et Tg, il faut donc que le niveau bas des horloges ne dépasse pas deux fois la tension de seuil des transistors.

Ainsi, ce dispositif perfectionne la présente invention dans la mesure où il permet de minorer l'amplitude des horloges Φ1 et Φ2 de deux fois la tension de seuil des transistors, soit, dans l'exemple des transistors en silicium amorphe (a-Si), une valeur comprise entre 5 et 7 volts.

Un troisième mode de réalisation la présente invention est représenté sur la figure 6 et permet, comme le mode précédent, d'utiliser des signaux d'entrée d'amplitudes réduites. Cette solution ne nécessite que quatre transistors.

On retrouve sur cette figure 6 les trois transistors Tl, Tp et Td, les deux entrées J-1 en 22 et J+1 en 30 correspondant respectivement aux étages précédent et suivant, les deux entrées d'horloges Φ1 et Φ2 en opposition, la sortie J de l'étage 55 sur la ligne de sélection J associée, ainsi que les capacité Cp, C2, Cb et Cl, du mode de réalisation de l'invention et de son premier perfectionnement décrits sur les figures précédentes. Le fonctionnement de cette partie commune est identique à celui décrit précédemment.

Le perfectionnement provient cette fois du fait que les grilles des transistors de remise à zéro Tz et Tp peuvent être connectées par le noeud Z directement à la ligne J+1 ou à la ligne J+2, c'est à dire à la ligne de sortie du second étage suivant. Une telle structure permet de se passer des transistors Tr et Th, ainsi que des capacités Cc et Cg du dispositif précédent. Il est nécessaire dans ce cas, que le niveau bas de l'horloge qu'atteint J+2 lorsque J doit retourner à zéro soit suffisant pour rendre correctement passants les transistors Td et Tz (par exemple 10 volts pour du silicium amorphe).

Ce circuit allie donc simplicité, puisqu'il ne nécessite que quatre transistors, et performance puisqu'il peut permettre un gain de l'ordre de 10 volts sur les tensions de commande.

Un quatrième mode de réalisation de l'invention est représenté par la figure 7. Celui-ci diffère du mode de réalisation précédent de la figure 6 par le fait que les grilles des transistors Td et Tz ne sont plus connectées en commun aux lignes suivantes. La grille du transistor Tz est commandée par un signal de réinitialisation (signal de Reset), le transistor Td est commandé par la ligne suivante J+1 et connecte le noeud G à un signal V.

Le signal de Reset commandant la grille du transistor Tz est un signal constitué d'une courte impulsion de largeur T1 en retard de phase par rapport aux signaux d'horloge Φ1 et Φ2, et qui a une période égale à la moitié de celle de Φ1 et Φ2 comme cela est illustré par la figure 8. D'autre part, le transistor Td dont la grille est commandée par la ligne suivante J+1, est activé à sa source par un signal V de même fréquence que le signal de Reset commandant le transistor Tz, et de largeur T2 au début de chaque demi-période. Cela afin d'éviter que le transistor Td ne décharge trop rapidement le noeud G, avant que le noeud D, c'est à dire la ligne J, ne soit redescendue au niveau de la masse. En effet, lorsque V est positif pendant la durée T2, le transistor Td ne peut pas décharger le point G, de sorte que Tl peut ramener le potentiel de la ligne J (noeud D) à la masse. Ainsi, chaque sortie est mise à la masse à chaque temps d'adressage ligne pendant la courte durée T1. Ce mode de réalisation de l'invention peut être qualifié de "moyenne impédance" (basse impédance seulement pendant le temps où dure le Reset et haute impédance pendant le reste du temps).

Un cinquième mode de réalisation de l'invention représenté sur la figure 9 consiste à commander la grille du transistor Tz par un signal de Reset et de commander la grille du transistor Td par un signal d'horloge Φa choisi parmi trois signaux d'horloge Φa, Φb et Φc. La source du transistor Td est maintenue à un potentiel constant négatif V-. Comme le montre la figure 10, chacune de ces horloges est constituée d'une courte impulsion de durée T3 en retard sur les transitions de Φ1 et Φ2 alternées, et a une période de répétition triple de celle du signal de Reset. Les trois horloges Φa, Φb et Φc se déduisent les unes des autres par un retard égal à la période de Reset qui correspond à la période d'adressage ligne. Ce mode de réalisation peut être qualifié de "basse impédance".

D'autre part, la présente forme d'exécution de l'invention concerne aussi un perfectionnement à la présente invention à haute ou moyenne impédance, permettant de compenser les couplages capacitifs existant entre les lignes et les colonnes d'un écran utilisant ce type de drivers lignes.

En effet, comme le montre la figure 11 qui représente une partie schématique d'un écran comportant des colonnes i et des lignes j commandées par des drivers lignes Dj, lorsque les sorties d'un driver Dj d'une ligne de sélection j ne sont pas à basse impédance, il existe des couplages capacitifs non négligeables Cij entre les lignes i-1, i et i+1 et les colonnes j-1, j et j+1, qui, lorsque ces dernières sont au repos, peuvent induire des tensions inacceptables pouvant aller jusqu'au changement d'état des transistors situés approximativement aux intersections des lignes et colonnes de la matrice active et non représentés sur la figure 11.

Le perfectionnement consiste à compenser ces couplages par une colonne ou un bus f couplé capacitivement (Cfj) à chacune des lignes j-1, j et j+1 de l'écran. Cette capacité doit avoir une valeur voisine de la somme des capacités de couplage Cij entre une ligne et les colonnes qu'elle croise. La colonne f peut être activée à chaque changement de polarité sur les colonnes comme lors des inversions de trame ou des inversions de lignes. Un autre moyen pour commander cette colonne f peut être de lui associer au travers d'un comparateur 40, une ligne g couplée capacitivement (Cgi) elle-aussi aux colonnes i-1, i et 1+1 qu'elle croise. Cette ligne g permet ainsi de détecter les couplages avec les colonnes de l'écran et de corriger le potentiel de la colonne f grâce au couplage capacitif Cfg entre la colonne f et la ligne g. Ce perfectionnement s'applique de préférence à la présente invention mais peut être facilement étendue à tous les types d'écrans plats à matrice active commandés via des lignes et colonnes par des circuits périphériques externes ou intégrés à l'écran autres que celui selon l'invention.

La présente invention et ses perfectionnements s'appliquent à tous les registres à décalages à charges de sortie capacitives, et en particulier à des registres à décalages de circuit de commande intégrés adressant les lignes d'un écran de visualisation. Cette invention et ses perfectionnements peuvent aussi s'appliquer d'un manière générale à tous les circuits électroniques grandes surfaces réalisés avec des transistors en couches minces autres que celui selon l'invention, comme par exemple les scanners au contact pour télécopie ou les tables à digitaliser.

## Revendications

1. Registre à décalage (21) comportant une pluralité d'étages en cascade (J-1, J, J+1), chaque étage (J) étant connecté à deux signaux d'horloge (Φ1,Φ2) comportant une sortie (D) et **caractérisé en ce qu'**il est connecté de plus à la sortie de l'étage précédent (J-1) et à la sortie de l'étage suivant (J+1), et qu'il comporte un premier dispositif à semiconducteur de sortie (Tl) commutant la sortie associée (J) entre des valeurs hautes et basses d'un premier signal d'horloge (Φ1), ce premier dispositif semiconducteur (Tl) étant commandé par le potentiel d'un premier noeud (G) connecté :
. à la sortie de l'étage précédent (J-1) au travers d'un second dispositif semiconducteur (Tp) commandé par cette même sortie précédente (22),
. à un potentiel négatif (V-) au travers d'un troisième dispositif semiconducteur (Td) commandé par la sortie de l'étage suivant (J+1),
. à un second signal d'horloge (Φ2) complémentaire du premier signal d'horloge (φ1) au travers d'une première capacité (C2) de valeur équivalente à celle de la capacité parasite (Cp) du dispositif semiconducteur de sortie (TI),
. et à la sortie (D) associée à l'étage (J) au travers d'une seconde capacité (Cb) de valeur supérieure à celle de ladite capacité parasite (Cp).

2. Registre à décalage (45) comportant une pluralité d'étages en cascade (J-1, J, J+1), chaque étage (J) étant connecté à deux signaux d'horloge (Φ1, Φ2) comportant une sortie (D) et **caractérisé en ce qu'**il est connecté de plus à la sortie de l'étage précédent (J-1) et à la sortie de l'étage suivant (J+1), et qu'il comporte un premier dispositif à semiconducteur de sortie (Tl) commutant la sortie associée (J) entre des valeurs hautes et basses d'un premier signal d'horloge (Φ1), ce premier dispositif semiconducteur (TI) étant commandé par le potentiel d'un premier noeud (G) connecté :
. à la sortie de l'étage précédent (J-1) au travers d'un second dispositif semiconducteur (Tp) commandé par cette même sortie précédente (22),
. à un second signal d'horloge (Φ2) complémentaire du premier signal d'horloge (φ1) au travers d'une première capacité (C2) de valeur équivalente à celle de la capacité parasite (Cp) du dispositif semiconducteur de sortie (TI),
. à la sortie (D) associée à l'étage (J) au travers d'une seconde capacité (Cb) de valeur supérieure à celle de ladite capacité parasite (Cp), ladite sortie étant connectée à la masse (33) au travers d'un troisième dispositif semiconducteur (Tz) commandé par un second noeud (Z),
. et à la masse au travers d'un quatrième dispositif semiconducteur (Td) commandé par le second noeud (Z),
ce second noeud (Z) étant connecté par ailleurs :
. à la sortie (22) de l'étage précédent (J-1) au travers d'une quatrième capacité (Cc),
. à la masse au travers d'un cinquième dispositif semiconducteur (Tr) commandé par la sortie (22) de l'étage précédent (J-1),
. à la sortie (30) de l'étage suivant (J+1) au travers de sixième et septième transistors de clamp (Th, Tg) montés en parallèle et commandés, l'un par le second noeud (Z), l'autre par la sortie (30) de l'étage suivant (J+1),
. et à la borne du troisième dispositif semiconducteur (Tz) reliée à la masse (33), par une capacité (Cg).

3. Registre à décalage (55) comportant une pluralité d'étages en cascade (J-1, J, J+1), chaque étage (J) étant connecté à deux signaux d'horloge (Φ1, Φ2), comportant une sortie (D) et **caractérisé en ce qu'**il est connecté de plus à la sortie de l'étage précédent (J-1) et à la sortie de l'étage suivant (J+1) ou du second étage suivant (J+2), ledit étage (J) comportant un premier dispositif à semiconducteur de sortie (Tl) commutant la ligne de sélection associée (J) entre des valeurs hautes et basses d'un premier signal d'horloge (Φ1), ce premier dispositif semiconducteur (Tl) étant commandé par le potentiel d'un premier noeud (G) connecté :
. à la sortie de l'étage précédent (J-1) au travers d'un second dispositif semiconducteur (Tp) commandé par cette même sortie précédente (22),
. à un second signal d'horloge (Φ2) complémentaire du premier signal d'horloge (φ1) au travers d'une première capacité (C2) de valeur équivalente à celle de la capacité parasite (Cp) du dispositif semiconducteur de sortie (TI),
. à la sortie (D) associée à l'étage (J) au travers d'une seconde capacité (Cb) de valeur supérieure à celle de ladite capacité parasite (Cp), ladite sortie (D) étant connectée à la masse (32) au travers d'un quatrième dispositif semiconducteur (Tz) commandé par un second noeud (Z),
. à un potentiel négatif (V-) au travers d'un troisième dispositif semiconducteur (Td) commandé par le second noeud (Z) qui est par ailleurs connecté à la sortie (30) de l'étage suivant (J+1) ou du second étage suivant (J+2).

4. Registre à décalage (21) comportant une pluralité d'étages en cascade (J-1, J, J+1), chaque étage (J) étant connecté à deux signaux d'horloge (Φ1, Φ2) comportant une sortie (D) et **caractérisé en ce qu'**il est connecté de plus à la sortie de l'étage précédent (J-1) et à la sortie de l'étage suivant (J+1) et qu'il comporte un premier dispositif à semiconducteur de sortie (TI) commutant la sortie associée (J) entre des valeurs hautes et basses d'un premier signal d'horloge (Φ1), ce premier dispositif semiconducteur (TI) étant commandé par le potentiel d'un premier noeud (G) connecté :
. à la sortie (22) de l'étage précédent (J-1) au travers d'un second dispositif semiconducteur (Tp) commandé par cette même sortie précédente (22),
. à un signal (V) au travers d'un troisième dispositif semiconducteur (Td) commandé par la sortie de l'étage suivant (J+1),
. à un second signal d'horloge (Φ2) complémentaire du premier signal d'horloge (φ1) au travers d'une première capacité (C2) de valeur équivalente à celle de la capacité parasite (Cp) du dispositif semiconducteur de sortie (TI),
. et à la sortie (D) associée à l'étage (J) au travers d'une seconde capacité (Cb) de valeur supérieure à celle de ladite capacité parasite (Cp), cette sortie (D) étant reliée à la masse au travers d'un quatrième dispositif semiconducteur (Tz) commandé par un signal de remise à zéro.

5. Registre à décalage (21) comportant une pluralité d'étages en cascade (J-1, J, J+1), chaque étage (J) étant connecté à deux signaux d'horloge (Φ1, Φ2) comportant une sortie (D) et **caractérisé en ce qu'**il est connecté de plus à la sortie de l'étage précédent (J-1) et à la sortie de l'étage suivant (J+1) et qu'il comporte un premier dispositif à semiconducteur de sortie (Tl) commutant la sortie associée (J) entre des valeurs hautes et basses d'un premier signal d'horloge (Φ1), ce premier dispositif semiconducteur (Tl) étant commandé par le potentiel d'un premier noeud (G) connecté :
. à la sortie (22) de l'étage précédent (J-1) au travers d'un second dispositif semiconducteur (Tp) commandé par cette même sortie précédente (22),
. à un potentiel constant négatif (V-) au travers d'un troisième dispositif semiconducteur (Td) commandé par un signal d'horloge (Φa) choisi parmi trois signaux d'horloge (Φa, Φb, Φc),
. à un second signal d'horloge (Φ2) complémentaire du premier signal d'horloge (φ1) au travers d'une première capacité (C2) de valeur équivalente à celle de la capacité parasite (Cp) du dispositif semiconducteur de sortie (TI),
. et à la sortie (D) associée à l'étage (J) au travers d'une seconde capacité (Cb) de valeur supérieure à celle de ladite capacité parasite (Cp), cette sortie (D) étant reliée à la masse au travers d'un quatrième dispositif semiconducteur (Tz) commandé par un signal de mise à zéro.

6. Registre à décalage selon la revendication précédente, **caractérisé en ce que** chacun des signaux d'horloge (Φa, Φb, Φc) est constitué d'une courte impulsion (T3) en retard sur les transitions des premier (Φ1) et second (Φ2) signaux d'horloge.

7. Registre à décalage selon l'une quelconque des revendications précédentes, **caractérisé en ce que** ladite première capacité (C2) a une valeur légèrement supérieure à la valeur de la capacité parasite (Cp) du dispositif semiconducteur de sortie (Tl).

8. Registre à décalage selon l'une quelconque des revendications 1 à 6, **caractérisé en ce que** ladite première capacité (C2) a une valeur légèrement inférieure à la valeur de la capacité parasite (Cp) du dispositif semiconducteur de sortie (Tl).

9. Registre à décalage selon l'une quelconque des revendications précédentes, **caractérisé en ce que** les dispositifs semiconducteurs (Tl, Tp, Td, Tz, Tr, Th) sont des transistors au silicium amorphe.

10. Registre à décalage selon l'une des revendications précédentes, **caractérisé en ce que** les sorties (D,22,30) des étages (J-1, J, J+1) sont des lignes d'adressage d'une matrice active d'un écran à cristaux liquides.

11. Ecran de visualisation comportant des circuits de commande périphériques intégrés constitués de balayeurs de lignes de sélection et de balayeurs de colonnes, **caractérisé en ce qu'**au moins un de ces circuits comporte un registre à décalage selon l'une quelconque des revendications précédentes.

12. Ecran de visualisation comportant au moins un registre à décalage selon la revendication 10 et des circuits de commande périphériques intégrés ou externes à la plaque substrat sur laquelle est déposée ladite matrice active, constitués de balayeurs (Dj-1, Dj, Dj+1) des lignes de sélection (j-1,,j,,j+1) et de balayeurs de colonnes (i-1,i,+1) **caractérisé en ce qu'**il comporte en outre, une colonne conductrice supplémentaire (f) croisant les lignes de sélection (j-1,,j,,j+1) et couplée capacitivement (Cfi) à chacune de celles-ci de manière à ce que les capacités de couplage correspondantes (Cfi) aient chacune une valeur voisine de la somme des capacités de couplage (Cij) entre une ligne (j) et les colonnes qu'elle croise (i-1,i, +1).

13. Ecran de visualisation selon la revendication précédente, **caractérisé en ce qu'**est associée à cette colonne conductrice supplémentaire (f) une ligne conductrice supplémentaire (g) couplée capacitivement (Cfg) avec elle et associée avec elle au travers d'un circuit comparateur (40), cette ligne supplémentaire (g) étant couplée capacitivement à chacune des colonnes (i-1, i, i+1).

14. Ecran de visualiation selon l'une quelconque des revendications 12 et 13, **caractérisé en ce qu'**il comporte un ou plusieurs registres à décalage selon l'une quelconque des revendications 1 à 10 ainsi que les lignes et colonnes supplementaires selon l'une quelconque des revendications 12 et 13.

## Patentansprüche

1. Schieberegister (21) mit mehreren Stufen in Kaskade (J-1, J, J+1), wobei jede Stufe (J) mit zwei einen Ausgang (D) enthaltenden Taktsignalen (Φ1, Φ2) verbunden ist,
**dadurch gekennzeichnet, daß**
es außerdem mit dem Ausgang der vorangehenden Stufe (J-1) und mit dem Ausgang der folgenden Stufe (J+1) verbunden ist und eine erste Halbleitereinheit am Ausgang (Tl) enthält, die den zugehörigen Ausgang (J) zwischen hohen und niedrigen Werten eines ersten Taktsignals (Φ1) umschaltet und die erste Halbleitereinheit (Tl) durch die Spannung von einem ersten Schaltungspunkt (G) gesteuert wird, der verbunden ist mit:
- dem Ausgang der vorangehenden Stufe (J-1) über eine zweite Halbleitereinheit (Tp), die durch denselben vorangehenden Ausgang (22) gesteuert ist,
- einer negativen Spannung (V-) über eine dritte Halbleitereinheit (Td), die durch den Ausgang der folgenden Stufe (J+1) gesteuert ist,
- einem zu dem ersten Taktsignal (Φ1) komplementären zweiten Taktsignal (Φ2) über eine erste Kapazität (C2) mit einem Wert, der äquivalent ist zu dem der Streukapazität (Cp) der Ausgangs-Halbleitereinheit (Tl),
- dem zu der Stufe (J) gehörenden Ausgang (D) über eine zweite Kapazität (Cb) mit einem Wert, der größer ist als der der genannten Streukapazität (Cp).

2. Schieberegister (45) mit mehreren Stufen in Kaskade (J-1, J, J+1), wobei jede Stufe (J) mit zwei einen Ausgang (D) enthaltenden Taktsignalen (Φ1, Φ2) verbunden ist, **dadurch gekennzeichnet, daß** es mit dem Ausgang der vorangehenden Stufe (J-1) und mit dem Ausgang der folgenden Stufe (J+1) verbunden ist und eine erste Ausgangs-Halbleitereinheit (Tl) enthält, die den zugehörigen Ausgang (J) zwischen hohen und niedrigen Werten eines ersten Taktsignals (Φ1) umschaltet, und daß die erste Halbleitereinheit (Tl) durch die Spannung eines ersten Schaltungspunktes (G) gesteuert ist, der verbunden ist mit:
- dem Ausgang der vorangehenden Stufe (J-1) über eine zweite Halbleitereinheit (Tp), die durch denselben vorangehenden Ausgang (22) gesteuert ist,
- einem zu dem ersten Taktsignal (Φ1) komplementären zweiten Taktsignal (Φ2) über eine erste Kapazität (C2) mit einem Wert, der äquivalent zu der Streukapazität (Cp) der Ausgangs-Halbleitereinheit (Tl) ist,
- dem zu der Stufe (J) gehörenden Ausgang (D) über eine zweite Kapazität (Cb) mit einem Wert, der größer ist als derjenige der genannten Streukapazität (Cp), wobei der Ausgang über eine dritte Halbleitereinheit (Tz) mit Masse (33) verbunden ist, die durch einen zweiten Schaltungspunkt (Z) gesteuert ist,
- und mit Masse über eine vierte Halbleitereinheit (Td), die durch den zweiten Schaltungspunkt (Z) gesteuert ist,
daß der zweite Schaltungspunkt (Z) außerdem verbunden ist mit:
- dem Ausgang (22) der vorangehenden Stufe (J-1) über eine vierte Kapazität (Cc),
- mit Masse über eine fünfte Halbleitereinheit (Tr), die durch den Ausgang (22) der vorangehenden Stufe (J-1) gesteuert ist,
- mit dem Ausgang (30) der folgenden Stufe (J+1) über einen sechsten und einen siebten Klemmtransistor (Th, Tg), die parallel geschaltet sind und von denen einer durch den zweiten Schaltungspunkt (Z) und der andere durch den Ausgang (30) der folgenden Stufe (J+1) gesteuert ist,
- und mit der Anschlußklemme der dritten Halbleitereinheit (Tz), die über eine Kapazität (Cg) mit Masse (33) verbunden ist.

3. Schieberegister (55) mit mehreren Stufen in Kaskade (J-1, J, J+1), wobei jede Stufe (J) mit zwei, einen Ausgang (D) enthaltenden Taktsignalen (Φ1, Φ2) verbunden ist, **dadurch gekennzeichnet, daß** sie zusätzlich mit dem Ausgang der vorangehenden Stufe (J-1) und mit dem Ausgang der folgenden Stufe (J+1) oder der zweiten folgenden oder übernächsten Stufe (J+2) verbunden ist und die Stufe (J) eine erste Ausgangs-Halbleitereinheit (Tl) enthält, die die zugehörige Auswahlleitung (J) zwischen hohen und niedrigen Werten eines ersten Taktsignals (Φ1) umschaltet, und die erste Halbleitereinheit (Tl) durch die Spannung eines ersten Schaltungspunktes (G) gesteuert ist, der verbunden ist mit:
- dem Ausgang der vorangehenden Stufe (J-1) über eine zweite Halbleitereinheit (Tp), die durch denselben vorangehenden Ausgang (22) gesteuert ist,
- einem zu dem ersten Taktsignal (Φ1) komplementären zweiten Taktsignal (Φ2) über eine erste Kapazität (C2) mit einem Wert, der äquivalent ist zu dem der Streukapazität (Cp) der Ausgangs-Halbleitereinheit (Tl),
- dem zu der Stufe (J) gehörenden Ausgang (D) über eine zweite Kapazität (Cb) mit einem Wert, der größer ist als der der genannten Streukapazität (Cp), wobei der Ausgang (D) mit Masse (32) über eine vierte Halbleitereinheit (Tz) verbunden ist, die von einem zweiten Schaltungspunkt (Z) gesteuert ist,
- einer negativen Spannung (V-) über eine dritte Halbleitereinheit (Td), die von dem zweiten Schaltungspunkt (Z) gesteuert ist, der außerdem mit dem Ausgang (30) der folgenden Stufe (J+1) oder der zweiten folgenden oder übernächsten Stufe (J+2) verbunden ist.

4. Schieberegister (21) mit mehreren Stufen in Kaskade (J-1, J, J+1), wobei jede Stufe (J) mit zwei einen Ausgang (D) enthaltenden Taktsignalen (Φ1, Φ2) verbunden ist, **dadurch gekennzeichnet, daß** es außerdem mit dem Ausgang der vorangehenden Stufe (J-1) und mit dem Ausgang der folgenden Stufe (J+1) verbunden ist und eine erste Ausgangs-Halbleitereinheit (Tl) enthält, die den zugehörigen Ausgang (J) zwischen hohen und niedrigen Werten eines ersten Taktsignals (Φ1) umschaltet, und die erste Halbleitereinheit (Tl) durch die Spannung eines ersten Schaltungspunktes (G) gesteuert ist, der verbunden ist mit:
- dem Ausgang (22) der vorangehenden Stufe (J-1) über eine zweite Halbleitereinheit (Tp), die durch denselben vorangehenden Ausgang (22) gesteuert ist,
- einem Signal (V) über eine dritte Halbleitereinheit (Td), die durch den Ausgang der folgenden Stufe (J+1) gesteuert ist,
- einem zu dem ersten Taktsignal (Φ1) komplementären zweiten Taktsignal (Φ2) über eine erste Kapazität (C2) mit einem Wert, der äquivalent ist zu dem der Streukapazität (Cp) der Ausgangs-Halbleitereinheit (Tl),
- dem zu der Stufe (J) gehörenden Ausgang (D) über eine zweite Kapazität (Cb) mit einem Wert, der größer ist als der der Streukapazität (Cp), wobei dieser Ausgang (D) mit Masse über eine vierte Halbleitereinheit (Tz) verbunden ist, die durch ein Signal zum Rücksetzen auf null gesteuert ist.

5. Schieberegister (21) mit mehreren Stufen in Kaskade (J-1, J, J+1), wobei jede Stufe (J) mit zwei einen Ausgang (D) enthaltenden Taktsignalen (Φ1, Φ2) verbunden ist, **dadurch gekennzeichnet, daß** sie außerdem mit dem Ausgang der vorangehenden Stufe (J-1) und mit dem Ausgang der folgenden Stufe (J+1) verbunden ist und eine erste Ausgangs-Halbleitereinheit (TI) enthält, die den zugehörigen Ausgang (J) zwischen hohen und niedrigen Werten eines ersten Taktsignals (Φ1) umschaltet, und die erste Halbleitereinheit (Tl) durch die Spannung eines ersten Schaltungspunktes (G) gesteuert ist, der verbunden ist mit:
- dem Ausgang (22) der vorangehenden Stufe (J-1) über eine zweite Halbleitereinheit (Tp), die durch denselben vorangehenden Ausgang (22) gesteuert ist,
- einer konstanten negativen Spannung (V-) über eine dritte Halbleitereinheit (Td), die durch ein Taktsignal (Φa) gesteuert ist, das unter drei Taktsignalen (Φa, Φb, Φc) ausgewählt ist,
- einem zu dem ersten Taktsignal (Φ1) komplementären zweiten Taktsignal (Φ2) über eine erste Kapazität (C2) mit einem Wert, der äquivalent ist zu dem der Streukapazität (Cp) der Ausgangs-Halbleitereinheit (Tl),
- und dem zu der Stufe (J) gehörenden Ausgang (D) über eine zweite Kapazität (Cb) mit einem Wert, der größer ist als der der Streukapazität (Cp), wobei dieser Ausgang (D) mit Masse über eine vierte Halbleitereinheit (Tz) verbunden ist, die durch ein Signal zum Rücksetzen auf null gesteuert ist.

6. Schieberegister nach dem vorangehendem Anspruch, **dadurch gekennzeichnet, daß** jedes der Taktsignale (Φa, Φb, Φc) durch einen kurzen Impuls (T3) gebildet ist, der gegenüber den Übergängen des ersten (Φ1) und des zweiten (Φ2) Taktsignals verzögert ist.

7. Schieberegister nach einem der vorangehenden Ansprüche, **dadurch gekennzeichnet, daß** die erste Kapazität (C2) einen Wert hat, der etwas größer ist als der Wert der Streukapazität (Cp) der Ausgangs-Halbleitereinheit (Tl).

8. Schieberegister nach einem der Ansprüche 1 bis 6, **dadurch gekennzeichnet, daß** die erste Kapazität (C2) einen Wert hat, der etwas kleiner ist als der Wert der Streukapazität (Cp) der Ausgangs-Halbleitereinheit (Tl).

9. Schieberegister nach einem der vorangehenden Ansprüche, **dadurch gekennzeichnet, daß** die Halbleitereinheiten (Tl, Tp, Td, Tz, Tr, Th) Transistoren aus amorphem Silizium sind.

10. Schieberegister nach einem der vorangehenden Ansprüche, **dadurch gekennzeichnet, daß** die Ausgänge (D, 22, 30) der Stufen (J-1, J, J+1) Adressierleitungen einer aktiven Matrix eines Flüssigkristallschirms sind.

11. Bildschirm mit peripheren integrierten Steuerschaltungen für Abtasteinheiten für Auswahlleitungen und Abtasteinheiten für Spalten, **dadurch gekennzeichnet, daß** wenigstens eine der Schaltungen ein Schieberegister nach einem der vorangehenden Ansprüche enthält.

12. Bildschirm mit wenigstens einem Schieberegister nach Anspruch 10 und integrierten oder externen peripheren Steuerschaltungen auf einer Substratplatte, auf die die aktive Matrix aufgebracht ist, gebildet aus Abtasteinheiten (Dj-1, Dj, Dj+1) für Auswahlleitungen (j-1, j, j+1) und Abtasteinheiten für Spalten (i-1, i, i+1), **dadurch gekennzeichnet, daß** es außerdem eine zusätzliche leitende Spalte (f) enthält, die die Auswahlleitungen (j-1, j, j+1) kreuzt und kapazitiv (Cfi) mit jeder von ihnen derart gekoppelt ist, daß die entsprechenden Koppelkapazitäten (Cfi) jede einen Wert in der Nähe der Summe der Koppelkapazitäten (Cij) zwischen einer Leitung (j) und den Spalten (i-1, i, i+1) aufweisen, die sie kreuzt.

13. Bildschirm nach dem vorangehendem Anspruch, **dadurch gekennzeichnet, daß** der zusätzlichen leitenden Spalte (f) eine zusätzliche leitende Leitung (g) zugeordnet ist, die kapazitiv (Cfg) mit dieser gekoppelt ist, der sie über eine Komparatorschaltung (40) zugeordnet ist, und daß die zusätzliche Leitung (g) kapazitiv mit jeder der Spalten (i-1, i, i+1) gekoppelt ist.

14. Bildschirm nach einem der Ansprüche 12 und 13, **dadurch gekennzeichnet, daß** er ein oder mehrere Schieberegister nach einem der Ansprüche 1 bis 10 sowie zusätzliche Reihen und Spalten nach einem der Ansprüche 12 und 13 enthält.

## Claims

1. Shift register (21) containing a plurality of cascaded stages (J-1, J, J+1), each stage (J) being connected up to two clock signals (Φ1, Φ2) containing an output (D) and **characterized in that** it is connected moreover to the output of the preceding stage (J-1) and to the output of the next stage (J+1), and that it includes a first semiconductor output device (Tl) switching the associated output (J) between high and low values of a first clock signal ( Φ1), this first semiconductor device (Tl) being controlled by the potential of a first node (G) connected:
· to the output of the preceding stage (J-1) across a second semiconductor device (Tp) controlled by this same preceding output (22),
· to a negative potential (V-) across a third semiconductor device (Td) controlled by the output of the next stage (J+1),
· to a second clock signal (Φ2) complementary to the first clock signal (Φ1) across a first capacitance (C2) of a value equivalent to that of the stray capacitance (Cp) of the output semi-conductor device (T1),
· and to the output (D) associated with the stage (J) across a second capacitance (Cb) of a value above to that of the said stray capacitance (Cb).

2. Shift register (45) containing a plurality of cascaded stages (J-1, J, J+1), each stage (J) being connected up to two clock signals (Φ1, Φ2) containing an output (D) and **characterized in that** it is connected moreover to the output of the preceding stage (J-1) and to the output of the next stage (J+1), and that it includes a first semiconductor output device (TI) switching the associated output (J) between high and low values of a first clock signal (Φ1), this first semiconductor device being controlled by the potential of a first node (G) connected:
· to the output of the preceding stage (J-1) across a second semiconductor device (Tp) controlled by this same preceding output (22),
· to a second clock signal (Φ2) complementary to the first clock signal (Φ1) across a first capacitance (C2) of a value equivalent to that of the stray capacitance (Cp) of a value above that of the said stray capacitance (Cp) of the output semiconductor device (T1),
· to the output (D) associated with the stage (J) across a second capacitance (Cb) of a value above that of the said stray capacitance, the said output being connected to earth (33) across a third semiconductor device (Tz) controlled by a second node (Z),
· and to earth across a fourth semiconductor device (Td) controlled by the second node (Z),
this second node (Z) being connected moreover:
· to the output (22) of the preceding stage (J-1) across a fourth capacitance (Cc),
· to earth across a fifth semiconductor device (Tr) controlled by the output (22) of the preceding stage (J-1),
· to the output (30) of the next stage (J+1) across sixth and seventh clamping transistors (Th, Tg) mounted in parallel and controlled, one by the second node (Z) and the other by the output (30) of the next stage (J+1),
· and to that terminal of the third semiconductor device (Tz) connected to earth (33), by a capacitance (Cg).

3. Shift register (55) containing a plurality of cascaded stages (J-1, J, J+1), each stage (J) being connected up to two clock signals (Φ1, Φ2) containing an output (D) and **characterized in that** it is connected moreover to the output of the preceding stage (J-1) and to the output of the next stage (J+1) or of the next but one stage (J+2), the said stage (J) including a first semiconductor output device (Tl) switching the associated selection line (J) between high and low values of a first clock signal (Φ1), this first semiconductor device (Tl) being controlled by the potential of a first node (G) connected:
· to the output of the preceding stage (J-1) across a second semiconductor device (Tp) controlled by this same preceding output (22),
· to a second clock signal (Φ2) complementary to the first clock signal (Φ1) across a first capacitance (C2) of a value equivalent to that of the stray capacitance (Cp) of the output semi-conductor device (T1).
· to the output (D) associated with the stage (J) across a second capacitance (Cb) of a value above that of said stray capacitance (Cp), the said output being connected to earth (32) across a fourth semiconductor device (Tz) controlled by a second node (Z),
· to a negative potential (V-) across a third semiconductor device (Td) controlled by the second node (Z) which is moreover connected to the output (30) of the next stage (J+1) or of the next but one stage (J+2).

4. Shift register (21) containing a plurality of cascaded stages (J-1, J, J+1), each stage (J) being connected up to two clock signals (Φ1, Φ2) containing an output (D) and **characterized in that** it is connected moreover to the output of the preceding stage (J-1) and to the output of the next stage (J+1), and that it includes a first semiconductor output device (Tl) switching the associated output (J) between high and low values of a first clock signal ( Φ1), this first semiconductor device (Tl) being controlled by the potential of a first node (G) connected:
· to the output (22) of the preceding stage (J-1) across a second semiconductor device (Tp) controlled by this same preceding output (22),
· to a signal (V) across a third semiconductor device (Td) controlled by the output of the next stage (J+1),
· to a second clock signal (Φ2) complementary of the first clock signal (Φ1) across a first capacitance (C2) of a value equivalent to that of the stray capacitance (Cp) of an output semi-conductor device (T1),
· and to the output (D) associated with the stage (J) across a second capacitance (Cb) of a value above that of said stray capacitance (Cp), this output (D) being connected to earth across a fourth semiconductor device (Tz) controlled by a zero-reset signal.

5. Shift register (21) containing a plurality of cascaded stages (J-1, J, J+1), each stage (J) being connected up to two clock signals (Φ1, Φ2) containing an output (D) and **characterized in that** it is connected moreover to the output of the preceding stage (J-1) and to the output of the next stage (J+1), and that it includes a first semiconductor output device (TI) switching the associated output (J) between high and low values of a first clock signal ( Φ1), this first semiconductor device (Tl) being controlled by the potential of a first node (G) connected:
· to the output (22) of the preceding stage (J-1) across a second semiconductor device (Tp) controlled by this same preceding output (22),
· to a constant negative potential (V-) across a third semiconductor device (Td) controlled by a clock signal (Φa) chosen from three clock signals (Φ a, Φb, Φc),
· to a second clock signal (Φ2) complementary of the first clock signal (Φ1) across a first capacitance (C2) of a value equivalent to that of the stray capacitance (Cp) of the output semi-conductor device (T1),
· and to the output (D) associated with the stage (J) across a second capacitance (Cb) of a value above that of said stray capacitance (Cp), this output (D) being connected to earth across a fourth semiconductor device (Tz) controlled by a zero-reset signal.

6. Shift register according to the preceding claim, **characterized in that** each of the clock signal (Φa, Φb, Φc) consists of short pulse (T3) lagging behind the transitions of the first (Φ1) and second (Φ2) clock signals.

7. Shift register according to any one of the preceding claims, **characterized in that** the first capacitance (C2) has a value slightly greater than the value of the stray capacitance (Cp) of the semiconductor output device (T1).

8. Shift register according to any one of claims 1 to 6, **characterized in that** the first capacitance (C2) has a value slightly less than the value of the stray capacitance (Cp) of the semiconductor output device (T1).

9. Shift register according to any one of the preceding claims, **characterized in that** the semiconductor devices (Tl, Tp, Td, Tz, Tr, Th) are amorphous silicon transistors.

10. Shift register according to any one of the preceding claims, **characterized in that** the outputs (D, 22, 30) of the stages (J-1, J, J+1) are lines for addressing an active matrix of a liquid crystal screen.

11. Viewing screen containing integrated peripheral control circuits made up of selection line scanners and column scanners, **characterized in that** at least one of these circuits includes a shift register according to any one of the preceding claims.

12. Viewing screen including at least one shift register according to claim 10, peripheral control circuits, integrated with or external to the substrate board on which the active matrix is deposited, and which are made up of scanners (Dj-1, Dj, Dj+1) for selection lines (j-1,,j,,j+1) and of scanners for columns (i-1 , i, i+1), **characterized in that** it furthermore includes a supplementary conductive column (f) crossing over the selection lines (j-1,,j,,j+1) and capacitively coupled (Cfi) to each of them in such a way that corresponding coupling capacitances (Cfi) each have a value close to the sum of the coupling capacitances (Cij) between a line (j) and the columns which it crosses (i-1 , i, i+1).

13. Viewing screen according to the preceding claim, **characterized in that** associated with this supplementary conductive column (f) is a supplementary conductive line (g) capacitively coupled (Cfg) with it and associated with it across a comparator circuit (40), this supplementary line (g) being coupled capacitively to each of the columns (i-1, i, i+1).

14. Viewing screen according to either one of claims 12 and 13, **characterized in that** it includes one or more shift registers according to any one of claims 1 to 10 as well as the supplementary lines and columns according to either one of claims 12 and 13.
